# FASCICULE DE BREVET EUROPEEN

(11) **EP 3 667 734 B1**
(45) Date de publication et mention de la délivrance du brevet: **20.04.2022**
(21) Numéro de dépôt: 19215408.6
(22) Date de dépôt: 11.12.2019
(51) Int. Cl.: H01L 29/78, H01L 21/336

(54) **PROCÉDÉ DE FABRICATION DE COMPOSANTS MICROÉLECTRONIQUES**
HERSTELLUNGSVERFAHREN VON MIKROELEKTRONISCHEN KOMPONENTEN
METHOD FOR MANUFACTURING MICROELECTRONIC COMPONENTS

(30) Priorité: 13.12.2018 FR 1872889
(43) Date de publication de la demande: 17.06.2020
(73) Titulaire: Commissariat à l'Energie Atomique et aux Energies Alternatives, 75015 Paris (FR)
(72) Inventeur: POSSEME, Nicolas, 38054 GRENOBLE CEDEX 09 (FR); LE ROYER, Cyrille, 38054 GRENOBLE CEDEX 09 (FR)
(74) Mandataire: Decobert, Jean-Pascal

(56) Documents cités:
- US-A1- 2002 182 795
- US-B1- 6 635 938
- US-B1- 9 780 209

## Description

### DOMAINE TECHNIQUE

La présente invention concerne en général le domaine de la fabrication de composants micro-électroniques. Sont particulièrement visés les composants obéissant à la technologie MOS, acronyme dérivant de l'expression anglaise Metal Oxide Semiconductor (pour semi-conducteur métal oxyde) généralement fabriqués en quantité sur un substrat, avec les deux types de dopage complémentaires (P et N) de sorte à former des circuits CMOS (pour Complementary Metal Oxide Semiconductor). Une application de l'invention concerne la fabrication de transistors, en particulier sur la base d'un substrat massif, encore dénommé bulk. Il peut s'agir de mémoires Flash dont les cellules de base sont des transistors.

### ÉTAT DE LA TECHNIQUE

Dans le domaine considéré ci-dessus, on connaît des technologies de fabrication de transistors basés sur des substrats de type massif, dénommés en anglais «bulk ». Ces substrats comprennent globalement une base en un matériau semi-conducteur, typiquement du silicium, et des zones électriquement isolantes, typiquement en dioxyde de silicium. Les zones électriquement isolantes sont exposées au niveau d'une des faces du substrat et délimitent des zones exposées faites du matériau semi-conducteur. Ainsi, les zones électriquement isolantes ont une fonction de séparation électrique entre différentes zones de matériau semi-conducteur, encore dénommées zones actives. Ces zones actives sont le lieu de fabrication de transistors. Il est en particulier connu de fabriquer les zones d'isolation électrique par la réalisation de tranchées latérales d'isolation dites STI, acronyme de l'anglais « shallow trench isolation » c'est-à-dire « tranchées d'isolation peu profondes ».

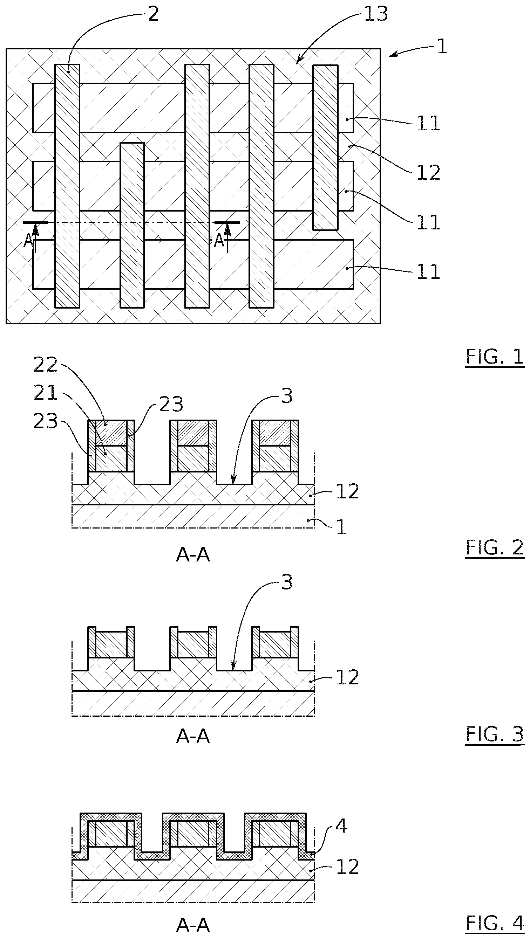

Dans ce contexte, la figure 1 présente en vue de dessus un schéma d'un substrat 1 doté, sur une première face 13, de zones exposées comprenant des zones actives 11 et des zones d'isolation électrique 12. Des grilles de transistors 21 peuvent être formées sur la base de barreaux de parties de grilles 2 dirigées transversalement, et plus particulièrement perpendiculairement, à l'orientation longitudinale des zones actives 11.

On sait par ailleurs que la réalisation de composants CMOS peut nécessiter l'ajout de couches permettant d'apporter de la contrainte (en compression ou respectivement en tension) permettant d'accroître les performances des dispositifs, en particulier des transistors à effet de champ (de type P ou respectivement N). Ces couches contraintes sont aussi appelées «stress liner». Leur efficacité dépend de l'épaisseur de la couche, souvent réalisé à base de nitrure de silicium. Mais leur dépôt provoque des défauts de remplissage qui se traduisent par la mise en court-circuit de composants micro-électroniques voisins.

Les figures 2 à 7B expliquent ces défauts. Elles représentent des vues en coupe au niveau de la ligne A-A de la figure 1, de sorte à montrer l'impact des étapes de fabrication sur les zones d'isolation électrique. Elles présentent de manière résumée des phases successives de fabrication de composants. À la figure 2, on a fabriqué, sur la base du substrat 1, des grilles 21 (généralement en polysilicium avec une couche électriquement isolante sous-jacente, typiquement d'oxyde, non représentée sur les figures). Par ailleurs, à ce stade, des espaceurs 23 ont été formés par un dépôt de couche d'espaceurs, typiquement du nitrure de silicium, et une gravure, avec les techniques bien connues de photolithographie et de gravure. Un masque dur 22 surplombe la grille 21 des transistors durant cette étape qui comporte aussi la fabrication de zones de sources/drains sur des portions de la zone active où le transistor est présent, de manière adjacente à la grille. Cette fabrication implique des dopages successifs, de type N et de type P pour former les deux natures de transistors des technologies CMOS. Durant ces étapes, la zone d'isolation électrique 12 est affectée de sorte qu'une zone consommée 3 apparaît à sa surface, sous forme de reliefs en creux.

De même, l'étape de retrait du masque dur 22 présentée à la figure 3 aggrave la consommation de matières isolantes au niveau de la zone 3.

Une étape suivante peut être le dépôt d'un revêtement de protection des grilles, sous forme d'une couche 4, par exemple de nitrure de silicium, telle qu'en figure 4. Cette protection doit ensuite être retirée sélectivement sur les parties horizontales pour dégager le haut de la grille et la surface des zones d'isolation, comme le montre la figure 5 avec des ouvertures 41 dans la couche de protection 4, induisant une consommation supplémentaire du matériau d'isolation à ce niveau. Des étapes suivantes sont présentées à la figure 6 avec une siliciuration d'une portion 5 du haut de la grille.

À noter que ces étapes incluent généralement un ou plusieurs traitements thermiques ainsi que des phases de nettoyage également dommageables à l'intégrité du matériau des zones d'isolation.

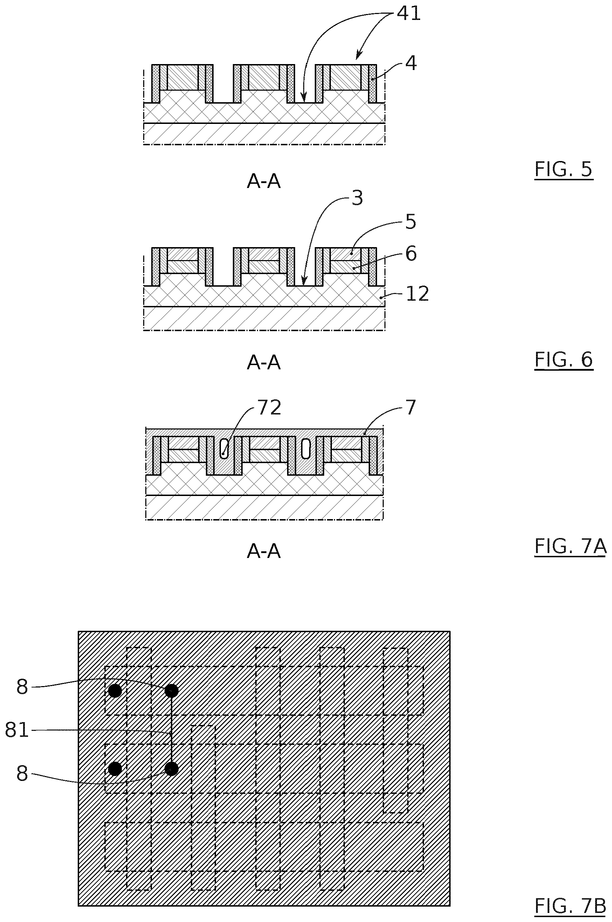

Finalement, une couche contrainte 7 peut être déposée. Compte tenu de la consommation indésirable des zones d'isolation électrique entre deux transistors adjacents, le rapport de forme des motifs formés en creux à ce niveau est augmenté ce qui ne pénalise la fiabilité du remplissage des espaces entre deux transistors adjacents. La figure 7A révèle que des vides 72 peuvent subsister au sein même de la matière de la couche contrainte 7. Ces vides résiduels interdisent par ailleurs un remplissage complet par d'autres couches au-dessus de la couche contrainte 7, et en particulier une couche supérieure d'isolant électrique, généralement en dioxyde de silicium, en particulier lorsque l'étage de transistors ainsi constitué est noyé en milieu de ligne (de l'anglais «middle of line ») d'un dispositif micro-électronique complet. Les défauts constitués par ces vides résiduels peuvent avoir des conséquences néfastes lorsqu'un vide est ouvert par des contacts électriques formés ultérieurement et ayant en particulier un problème d'alignement. Dans ce cas, lors du dépôt du matériau conducteur (par exemple du tungstène), notamment par dépôt chimique en phase vapeur, le défaut se trouve comblé par le matériau conducteur et créerait un court-circuit entre deux zones de contact de deux zones actives adjacentes qui ne sont pas censées être connectées électriquement. La figure 7B révèle de manière schématique deux éléments de contact 8 présents sur des zones actives 11 adjacentes et reliés par une zone de court-circuit 81 formée de manière indésirable au travers d'un vide résiduel lié à un défaut de remplissage de la couche contrainte et de la couche d'oxyde surmontant les transistors.

Au regard de ces inconvénients, il est actuellement nécessaire de préserver un espace important entre deux transistors adjacents ce qui implique soit une limitation de densité d'implantation des transistors sur le substrat, soit une étape de gravure de la couche de protection 4 pour accroître la largeur des espaces entre les transistors, ce qui constitue une étape supplémentaire et qui peut d'autre part affecter les autres constituants, en particulier la portion siliciurée, le matériau semi-conducteur des zones actives ou encore le matériau des zones d'isolation lui-même.

Il existe par conséquent un besoin d'améliorer les techniques de fabrication de composants micro-électroniques actuelles.

Le document US 2002/182795 A1 divulgue un procédé de fabrication d'un transistor à semi-conducteur utilisant des espaceurs en forme de L pour former des régions de source/drain. Le document US 6635938 B1 divulgue un procédé de fabrication d'un dispositif semi-conducteur dans lequel l'isolation électrique entre les transistors est assurée par des régions d'isolation STI.

### RÉSUMÉ

L'invention concerne un procédé de réalisation d'au moins un composant microélectronique sur un substrat (1) qui comporte, de manière exposée sur une première face du substrat (1), au moins une zone active (11) et au moins une zone d'isolation électrique (12) adjacente à la zone active (11), le procédé comprenant une formation d'une grille (21) de transistor sur la zone active (11), une formation d'espaceurs (23) chacun configuré pour couvrir une surface d'un flanc différent de la grille (21), et une formation de zones de source et de drain par dopage de portions de la zone active adjacentes à la grille, le procédé comprenant, de manière successive :- une formation d'une première couche (100), en un matériau d'espaceur, au-dessus de la zone active (11) et au-dessus de la zone d'isolation électrique (12) ;- une implantation ionique configurée pour produire le dopage des portions de la zone active (11) adjacentes à la grille (21) au travers de la première couche (100), la première couche (100) formant un revêtement de protection de la zone d'isolation électrique (12) durant toute l'implantation et jusqu'à son achèvement ;- une élimination d'une portion modifiée de la première couche (100) située en surplomb de la zone active (11) et de la zone d'isolation électrique (12), ladite portion modifiée étant issue de l'implantation ionique, ladite élimination étant configurée pour préserver, au moins en partie, la première couche (100) au niveau des flancs de la grille (21). Durant cette phase, l'élimination de la portion modifiée de la première couche concerne avantageusement l'ensemble de la zone active et la zone d'isolation électrique.

De manière avantageuse, durant l'implantation ionique, la première couche forme un revêtement de protection de la zone d'isolation électrique, et ce durant toute l'implantation et jusqu'à son achèvement, y compris si l'implantation comporte plusieurs étapes d'implantation.

On tire profit d'une séquence de formation des espaceurs pour générer, temporairement, un revêtement de protection des zones destinées à former les sources/drains. Ce revêtement sert durant au moins une phase d'implantation ionique mise en œuvre pour doper les portions produisant les sources et les drains (phase d'implantation qui comprend généralement plusieurs sous-phases, notamment pour produire les deux types de dopage, N et P des techniques CMOS). Avantageusement, le revêtement créé grâce à la première couche en un matériau d'espaceur reste en place jusqu'à ce que le dopage complet soit atteint ; en particulier, lorsque plusieurs implantations se suivent (par exemple un premier dopage faible, puis un dopage plus fort), le revêtement peut être conservé jusqu'à leur achèvement.

Ainsi, l'implantation ne va pas, ou seulement de manière plus limitée qu'actuellement, impacter la zone d'isolation électrique. Cela évite de la dégrader alors que les techniques actuelles ont tendances à la creuser lors de la formation des sources/drains. Et ce creusement induit, comme précédemment décrit, des défauts d'isolation électrique dans la zone d'isolation électrique.

Dans la mesure où le revêtement de protection est issu d'une couche destinée à former des espaceurs, cette protection de l'isolant s'opère sans que le dépôt lui soit dédié. En effet, de manière avantageuse, au moins une partie des portions verticales de la première couche est conservée, pour former les espaceurs. Par conséquent, la présente invention détourne partiellement la fonction de la phase de formation d'espaceurs pour lui affecter une fonctionnalité supplémentaire.

Le procédé de l'invention est particulièrement utile dans le contexte, pour autant non limitatif, de recouvrement ultérieur de la zone d'isolation par au moins une autre couche, notamment au moins l'une parmi une couche contrainte et une couche isolante. En effet, la formation de ces couches s'opère alors avec un meilleur remplissage des espaces entres les motifs que forment les composants et qui se trouvent pour certains sur la zone d'isolation. On évite des vides résiduels qui sont dommageables car ils peuvent se remplir ultérieurement de matériaux conducteurs d'électricité, en particulier lors de la formation d'éléments conducteurs tels que des contacts électriques de reprise pour les sources, drains et grilles de transistors.

L'invention concerne aussi un composant électronique obtenu par les aspects décrits du procédé de l'invention.

### BRÈVE DESCRIPTION DES FIGURES

Des buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 schématise, en vue de dessus, un substrat de fabrication de composants micro-électroniques.
La figure 2 présente une phase de fabrication de transistors selon l'État la technique.
La figure 3 montre une étape de retrait de masque, ultérieure à celle de la figure 2.
La figure 4 montre une étape de dépôt d'une protection, ultérieure à celle de la figure 3.
La figure 5 montre une étape de gravure, ultérieure à celle de la figure 4.
La figure 6 montre une étape de siliciuration, ultérieure à celle de la figure 5.
La figure 7A présente la formation d'une couche contrainte.
La figure 7B présente une vue de dessus schématisant un court-circuit entre deux contacts électriques.

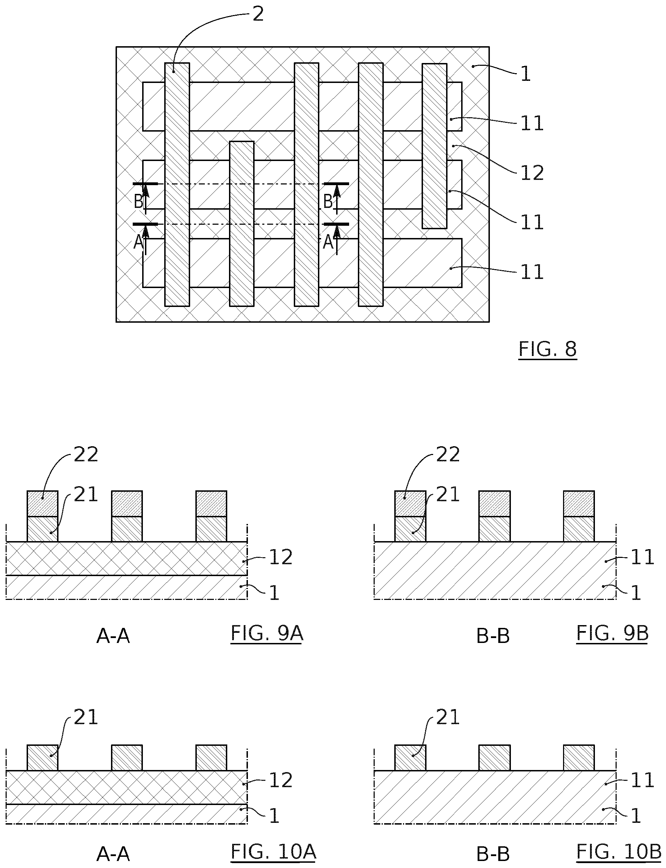

La figure 8 est une vue de dessus équivalent à celle de la figure 1 et révélant deux lignes de coupe AA et BB utilisées dans les figures qui suivent pour présenter des modes de réalisation de l'invention.
La figure 9A schématise une phase de fabrication d'un composant micro-électronique, selon invention et selon les lignes A-A de la figure 8.
La figure 9B montre l'étape de la figure précédente, au niveau de la coupe selon la ligne B-B.
La figure 10A présente le retrait d'un masque.
La figure 10B montre l'étape de la figure précédente, au niveau de la coupe selon la ligne B-B.

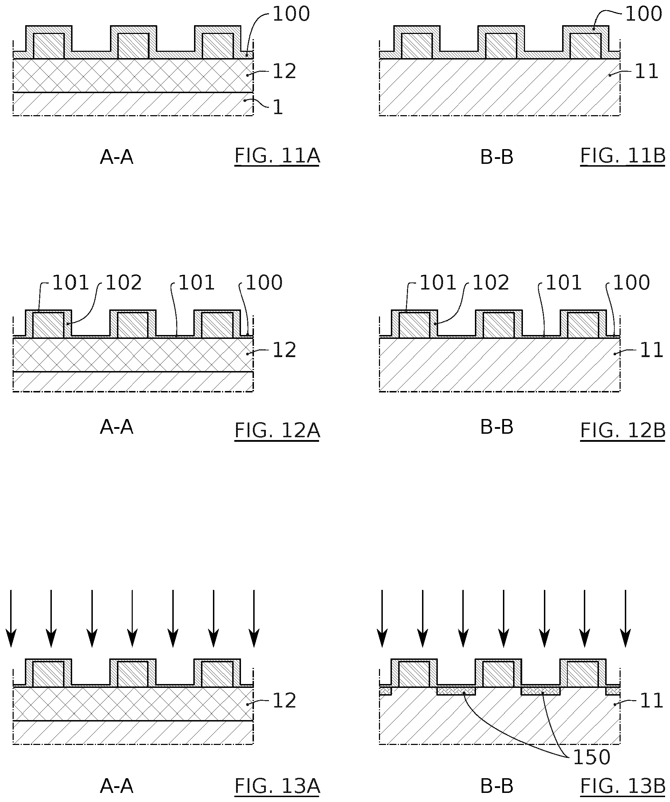

La figure 11A illustre le dépôt d'une première couche.
La figure 11B montre l'étape de la figure précédente, au niveau de la coupe selon la ligne B-B.
La figure 12A révèle le résultat d'une gravure anisotrope.
La figure 12B montre l'étape de la figure précédente, au niveau de la coupe selon la ligne B-B.
La figure 13A présente une phase d'implantation.
La figure 13B montre l'étape de la figure précédente, au niveau de la coupe selon la ligne B-B.

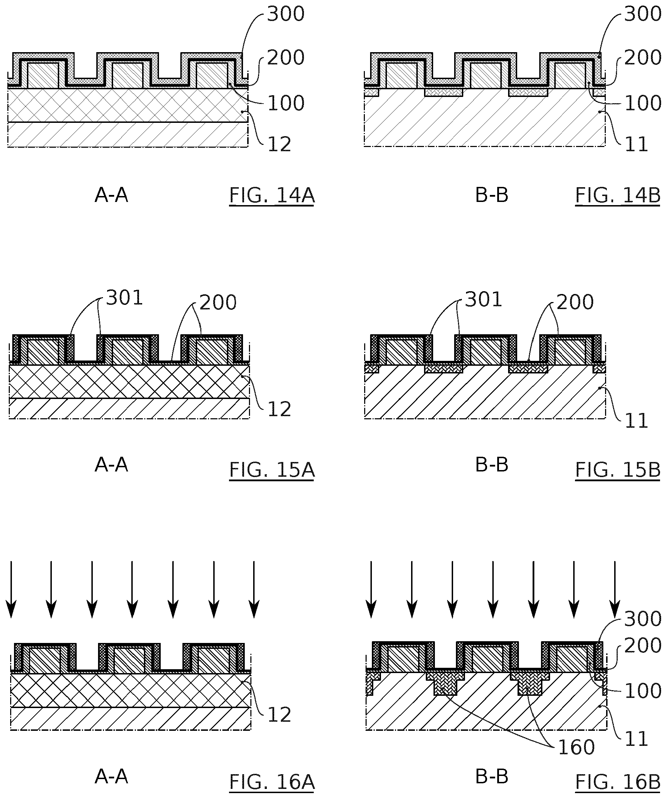

La figure 14A correspond au dépôt d'une couche intermédiaire et d'une couche supérieure.
La figure 14B montre l'étape de la figure précédente, au niveau de la coupe selon la ligne B-B.
La figure 15A montre un retrait partiel de la couche supérieure.
La figure 15B montre l'étape de la figure précédente, au niveau de la coupe selon la ligne B-B.
La figure 16A présente une deuxième implantation.
La figure 16B montre l'étape de la figure précédente, au niveau de la coupe selon la ligne B-B.

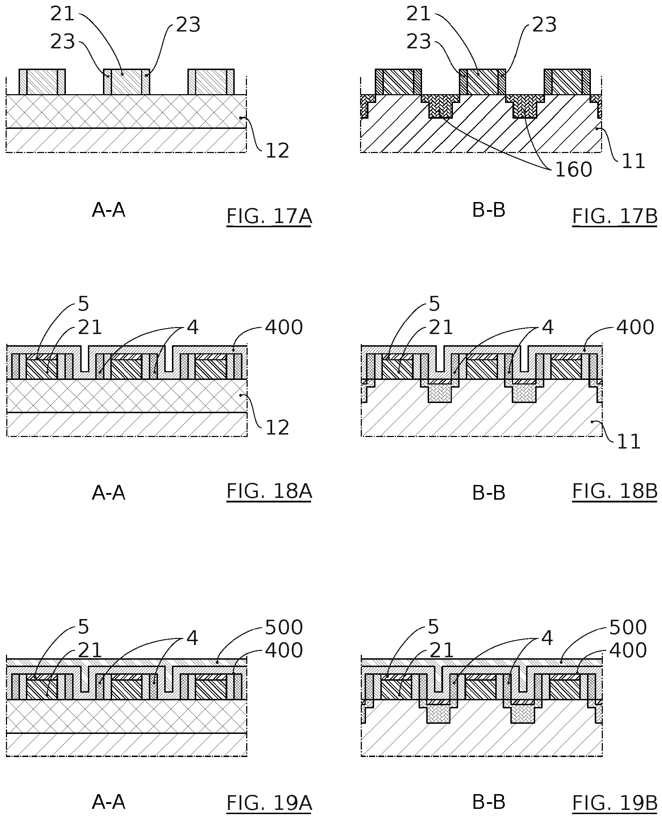

La figure 17A est le résultat d'un retrait d'une partie des couches.
La figure 17B montre l'étape de la figure précédente, au niveau de la coupe selon la ligne B-B.
La figure 18A présente une étape ultérieure avec formation d'une protection sur les espaceurs et d'une couche contrainte.
La figure 18B montre l'étape de la figure précédente, au niveau de la coupe selon la ligne B-B.
La figure 19A reflète l'efficacité de remplissage des espaces entre les transistors par une couche électriquement isolante.
La figure 19B montre l'étape de la figure précédente, au niveau de la coupe selon la ligne B-B.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches ne sont pas représentatives de la réalité. Dans la présente demande de brevet, l'épaisseur est prise selon une direction perpendiculaire aux faces principales du substrat sur lesquelles reposent les différentes couches. Sur les figures, l'épaisseur est prise selon la verticale.

### DESCRIPTION DÉTAILLÉE

Avant d'entamer une revue détaillée de modes de réalisation de l'invention, sont énoncées ci-après des caractéristiques optionnelles d'aspects de l'invention qui peuvent éventuellement être utilisées en association ou alternativement :
- un retrait partiel préliminaire de la première couche 100 est opéré avant l'implantation, avec une gravure anisotrope configurée pour réduire, sans l'éliminer totalement, l'épaisseur de la première couche 100 au-dessus des portions de la zone active 11 adjacentes à la grille 21 ou plus généralement au-dessus de la zone active 11 et/ou au-dessus de la zone d'isolation électrique 12 ;
- la gravure anisotrope est configurée pour préserver une épaisseur de la première couche 100 d'au moins 2 nm, et de préférence 3 nm, au-dessus des portions de la zone active 11 adjacentes à la grille 21 ou plus généralement au-dessus de la zone active 11 et/ou au-dessus de la zone d'isolation électrique 12 ;
- la gravure anisotrope est configurée pour préserver une épaisseur de la première couche 100 d'au plus 5 nm au-dessus des portions de la zone active 11 adjacentes à la grille 21 ou plus généralement au-dessus de la zone active 11 et/ou de la zone d'isolation électrique 12 ;
- l'implantation ionique comprend plusieurs implantations, et notamment une première implantation et une deuxième implantation ;
- le procédé comprend successivement, après la première implantation ionique et avant l'élimination de la portion modifiée : une formation, sur la première couche, d'au moins une couche supplémentaire ; une deuxième implantation ionique configurée pour produire un deuxième dopage des portions de la zone active 11 adjacente à la grille 21.
- Éventuellement, la formation, sur la première couche, d'au moins une couche supplémentaire peut comprendre : une formation, sur la première couche, d'une couche intermédiaire en un deuxième matériau différent du matériau d'espaceurs ; et une formation, sur la couche intermédiaire, d'une couche supérieure en un troisième matériau différent du deuxième matériau.
- Optionnellement, après la formation de la couche supérieure, on peut procéder à : un retrait, au moins partiel, des parties horizontales de la couche supérieure avec une première gravure, anisotrope ; la deuxième implantation ionique ; un retrait complet de la couche supérieure, comprenant une deuxième gravure employant la couche intermédiaire comme couche d'arrêt ; un retrait complet de la couche intermédiaire, comprenant une troisième gravure qui est sélective relativement au matériau d'espaceurs.
- le procédé comprend éventuellement successivement, après l'implantation ionique et avant l'élimination d'une portion modifiée :
   une formation, sur la première couche 100, d'une couche intermédiaire 200, en un deuxième matériau différent du matériau d'espaceur;
   une formation, sur la couche intermédiaire 200, d'une couche supérieure 300, en un troisième matériau différent du deuxième matériau;
   un retrait, au moins partiel, des parties horizontales de la couche supérieure 300 avec une première gravure, anisotrope ;
   une deuxième implantation ionique configurée pour produire un deuxième dopage des portions de la zone active 11 adjacentes à la grille 1;
   un retrait complet de la couche supérieure 300 comprenant une deuxième gravure employant la couche intermédiaire 200 comme couche d'arrêt;
   un retrait complet de la couche intermédiaire 200, comprenant une troisième gravure qui est sélective relativement au matériau d'espaceur ;
- le retrait des parties horizontales de la couche supérieure 300 est total, en employant la couche intermédiaire 200 comme couche d'arrêt de la première gravure ;
- la troisième gravure est configurée pour produire, après le retrait de la couche intermédiaire 200, l'élimination d'une portion modifiée de la première couche 100, ladite portion modifiée étant issue de l'implantation ionique ;
- la deuxième gravure est isotrope ;
- la troisième gravure est isotrope ;
- le troisième matériau est choisi identique au matériau d'espaceur ;
- le procédé selon l'invention comprend, après l'élimination d'une portion modifiée, une formation d'au moins une couche contrainte 400 configurée pour couvrir, en la mettant en tension ou en compression, une portion du substrat 1 comprenant au moins une zone de source ou une zone de drain ;
- après la formation de l'au moins une couche contrainte 400, le procédé comprend une formation d'une couche électriquement isolante 500 ;
- après la formation d'une couche électriquement isolante, le procédé comprend une formation d'au moins un élément de contact électrique 8 en liaison électrique avec une zone de drain ou de source sous-jacent ;
- on utilise un substrat 1 massif dont au moins une zone active 1 est en un matériau semi-conducteur et dont au moins une zone d'isolation électrique 12 est une tranchée d'isolation électrique.
- le procédé est configuré pour la fabrication d'au moins un composant microélectronique du type MOS.

Il est précisé que dans le cadre de la présente invention, le terme « sur », « surmonte », « recouvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais cela signifie que la première couche recouvre au moins partiellement la deuxième couche en étant soit directement à son contact soit en étant séparée d'elle par au moins une autre couche ou au moins un autre élément. D'une manière générale, une couche peut comprendre une ou plusieurs sous-couches.

La présente invention permet la fabrication d'au moins un composant mais généralement d'une pluralité de composants micro-électroniques sur un substrat. Par composant, dispositif ou élément de dispositif microélectronique, on entend tout type d'élément réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

Certaines parties du dispositif peuvent avoir une fonction électrique. Certaines sont employées pour des propriétés de conduction électrique et on entend par électrode ou équivalent, des éléments formés d'au moins un matériau ayant une conductivité suffisante, dans l'application, pour réaliser la fonction souhaitée. D'autres parties, au contraire, sont employées pour des propriétés d'isolation électrique et tout matériau ayant une résistivité suffisante pour réaliser cette isolation est concerné et est notamment appelé diélectrique.

On décrit ci-après un ou plusieurs modes de réalisation de l'invention mettant en œuvre des étapes successives d'un procédé de fabrication de composants micro-électroniques sur la base d'un substrat. À moins qu'il en soit disposé autrement, l'adjectif « successif » n'implique pas nécessairement, même si cela est généralement préféré, que les étapes se suivent immédiatement, des étapes intermédiaires pouvant les séparer. Par ailleurs, le terme « étape » s'entend de la réalisation d'une partie du procédé, ce qui peut comprendre plusieurs sous étapes.

La représentation de la figure 8 est semblable à celle de la figure 1 en ce sens que le procédé de l'invention peut être basé sur un substrat similaire à celui précédemment décrit en référence à l'état de la technique exposé avec le support des figures 1 à 7B. Ainsi, on retrouve la figure 8 un substrat 1 généralement fait d'un matériau semi-conducteur pour sa base et comprenant sur une de ses faces des zones 11 et 12 produisant respectivement des parties actives (de construction de composants micro-électroniques proprement dits) et des parties d'isolation électrique. Comme précédemment, les zones actives 11 peuvent être faites de matériau semi-conducteur, tel que du silicium, et/ou les zones d'isolation électrique peuvent être en dioxyde de silicium et peuvent correspondre à la technologie de tranchée d'isolation peu profonde indiquée précédemment.

Un des aspects de la présente invention est d'autoriser une bonne protection des zones d'isolation électrique 12 tout en réalisant les étapes de transformation de zones actives 11 permettant de fabriquer les composants micro-électroniques. Pour bien appréhender ces deux aspects, les figures suivant la figure 8 présentent parallèlement des vues en coupe suivant la ligne A-A de la figure 8 (au niveau d'une zone d'isolation 12) et des vues en coupe suivant la ligne B-B de la figure 8 (au niveau d'une zone active 11).

Ainsi, la figure 9A présente de façon conventionnelle une grille 21 surplombant le substrat 1 et revêtue d'un masque dur 22 ayant servi à la fabrication de la grille 21 (cette dernière n'est pas exposée en détail et peut obéir à des étapes conventionnelles de lithographie et de gravure). Une vue équivalente est donnée en figure 9B au niveau de la zone active 11. La dimension critique de la grille peut être comprise entre 10 nm et 100 nm et est de préférence inférieure ou égale à 50 nm. Le pas entre deux grilles successives est de préférence inférieur ou égal à 120 nm. Par ailleurs, la hauteur de grille 21 est avantageusement inférieure ou égale à 100 nm, et de préférence de 50 nm. La hauteur du masque 22 peut notamment être comprise entre 40 et 80 nanomètres. Il pourra s'agir d'un masque en nitrure, notamment du nitrure de silicium.

Une étape suivante peut consister au retrait du masque dur 22, par exemple par une gravure isotrope (typiquement une gravure humide, par exemple utilisant une solution d'acide phosphorique, H₃PO₄). Le résultat ressort immédiatement des figures 10A et 10B.

La formation d'un transistor implique de manière connue en elle-même la création d'espaceurs 23 recouvrant tout ou partie des flancs des grilles 21. On entend par « flancs » les zones latérales des grilles 21, c'est-à-dire ayant une composante verticale. Dans le sens de la description, le terme « vertical » s'entend d'une direction orientée suivant l'épaisseur du substrat, cette direction n'étant pas à interpréter au sens strict, une partie verticale pouvant présenter une composante horizontale minoritaire. À l'inverse, le terme « horizontal » s'entend d'une direction suivant le plan du substrat. Dans la représentation de la figure 8, ses flancs s'étendent suivant une direction perpendiculaire aux lignes de coupe A-A et B-B. Un dépôt d'un matériau d'espaceur est réalisé au-dessus du substrat comportant les grilles 21 pour former une première couche 100.

De préférence, il s'agit d'un dépôt conforme. Il est, en outre, de préférence réalisé « pleine plaque » qui est aussi le cas préféré pour le dépôt des couches 200 et 300 discuté plus loin. Selon un exemple, le dépôt conforme est effectué par l'un des dépôts suivants : dépôt chimique en phase vapeur assisté par plasma (PECVD), dépôt chimique en phase vapeur assisté à basse pression (LPCVD), dépôt thermique rapide chimique en phase vapeur (RTCVD), dépôt physique en phase vapeur (PVD). On pourra utiliser, comme matériau d'espaceur, du nitrure de silicium ou encore un matériau de type Low-k (de constante diélectrique k<7 ; il peut s'agir de SiBCN ou de SiCO). D'une manière générale, une épaisseur de ce dépôt de moins de 15 nm est satisfaisante. L'épaisseur peut être comprise entre 6 nm et 15 nm, de préférence entre 8 nm et 12 nm et plus préférentiellement entre 9 et 10 nm. On obtient le résultat visible aux figures 11A et 11B.

Les figures 12A et 12B présentent une étape facultative mais avantageuse de l'invention selon laquelle on opère une gravure partielle et anisotrope de la couche 100 précédemment formée pour amincir les parties horizontales 101 de la couche 100 tout en préservant, ou en amincissant moins, les parties verticales 102, correspondant à celles destinées à couvrir les flancs de grilles 21. En particulier, une étape de l'invention, dans ce mode de réalisation préféré, consiste à amincir la couche 100 au niveau d'une portion horizontale 101 de celles-ci située entre deux grilles 21. L'amincissement de la partie horizontale 101 au-dessus des grilles 21 n'est pas nécessaire, et, dans le mode de réalisation indiqué ici pour l'amincissement, constitue un effet secondaire. D'une manière générale, il s'agira préférentiellement d'une gravure partielle anisotrope par plasma. On peut réaliser cet amincissement dans un réacteur à couplage inductif. De préférence, l'amincissement est configuré pour que l'épaisseur de la partie horizontale 101 entre les grilles 21 reste au moins égal à un seuil dimensionnel qui peut être d'au moins 3 nm. Il est cependant souhaitable que l'épaisseur résiduelle ne soit pas trop élevée, par exemple inférieure à 6 nm. Un seuil cible fixé à 5 nm, peut, dans cette gamme, donner satisfaction. De manière alternative ou complémentaire, on peut fixer le seuil en fonction de l'épaisseur du dépôt conforme du matériau d'espaceurs, par exemple en produisant un amincissement d'au moins 30 %, et de préférence 50 %, de cette épaisseur. Alternativement ou en complément, l'amincissement peut être supérieur ou égal à 70% de l'épaisseur initiale.

On comprend que le matériau d'espaceurs est préservé sur les parties horizontales 101 et non pas totalement supprimé à ces endroits. En effet, un aspect de l'invention est d'utiliser les parties horizontales 101, situées entre les grilles 21, comme revêtement de protection des matériaux sous-jacents, et en particulier du matériau de la zone d'isolation électrique 12. On verra dans les étapes qui suivent que cela permet d'assurer l'intégrité de la zone d'isolation électrique 12 dans certaines étapes de fabrication, notamment liées à l'implantation ionique. Cette intégrité s'entend du maintien en place du matériau des zones d'isolation, même si celui-ci peut subir des transformations liées à l'implantation ionique.

L'implantation ionique introduite au paragraphe précédent est présentée, dans une première phase, aux figures 13A et 13B. On verra que le procédé de l'invention peut comporter plusieurs phases d'implantation ionique, et notamment une première phase correspondant à celle des figures 13A et 13B et une deuxième phase illustrée plus loin, aux figures 16A et 16B. Ce mode de réalisation n'est cependant pas limitatif et l'invention peut être mise en œuvre avec d'autres phases d'implantation ionique ou une seule phase. Dans ce contexte, l'implantation ionique peut par exemple comprendre une première implantation correspondant à la phase d'implantation ionique décrite ci-après, et une deuxième implantation ionique, ultérieure, et en particulier réalisée après formation d'au moins une couche supplémentaire sur la première couche 100. Par ailleurs, une phase d'implantation ionique comprend de préférence des sous phases de sorte à produire différents types de dopage (P et N), pour parvenir à une fabrication de type CMOS et comprenant des composants NMOS et des composants PMOS. À cet effet, l'invention peut utiliser des techniques conventionnelles pour la réalisation des dopages proprement dits et la définition des zones à doper.

Selon un exemple, les paramètres de l'implantation, en particulier l'énergie des ions, sont choisis de manière à modifier par implantation une partie de l'épaisseur de la zone active 11 située entre deux grilles 21 pour produire les zones d'implantation 150, malgré le fait que l'implantation doit traverser la partie horizontale 101 de la couche 100 surmontant la zone d'implantation 150. Dans un mode de réalisation, la phase d'implantation correspondant aux figures 13 est du type faiblement dopé, et peut correspondre aux teneurs en espèces dopantes prévues dans les dopages de type «Lightly Doped Drain-Source (LDD) » c'est-à-dire de drain/source faiblement dopés. Une étape de simulation pourra permettre d'ajuster la dose et l'énergie.

Cette implantation étant faite, on procède avantageusement à d'autres étapes avant de retirer les parties horizontales 101 de la couche 100 surmontant les zones de source/drain. C'est en particulier avantageux pour préparer une deuxième implantation, qui peut être faite avec des doses de dopage plus élevées que la première, notamment dans le contexte d'une implantation du type «Highly Doped Drain-Source (HDD). Notamment, une option de mode de réalisation de la présente invention comprend la formation d'au moins une couche supplémentaire sur la première couche 100, cette formation étant réalisée après l'implantation ionique indiquée précédemment. On procède ensuite à la deuxième implantation, dont le secteur se trouve défini par le contour de la au moins une couche supplémentaire, éventuellement après les étapes supplémentaires de mise en forme de la au moins une couche supplémentaire, notamment des étapes de gravure partielle.

On notera que dans ce cas, la deuxième implantation intervient après la phase de dépôt d'au moins une couche supplémentaire, alors que l'implantation ionique initiale est intervenue avant la phase de dépôt d'au moins une couche supplémentaire.

C'est dans ce contexte que les figures 14A et 14B présentent une étape ultérieure comprenant le dépôt d'une couche intermédiaire 200 et le dépôt d'une couche supérieure 300. Ces deux couches sont faites de matériaux différents de sorte à produire une sélectivité lors d'une gravure qui sera décrite plus loin. Par exemple, la couche intermédiaire 200 peut être faite d'un oxyde de matériau semi-conducteur, et notamment de dioxyde de silicium. À titre d'exemple, son épaisseur peut être supérieure à 3 nm et/ou inférieure à 10 nm. Une épaisseur de 7 nm est préférée. Quant à la couche supérieure 300, il peut s'agir d'un nitrure de matériau semi-conducteur, et notamment de nitrure de silicium. À titre d'exemple, son épaisseur peut être supérieure à 20 nm et/ou inférieure à 40 nm. Une épaisseur de 30 nm est préférée. Avantageusement, au moins l'un de ces dépôts, mais préférentiellement les deux, est réalisé de manière conforme notamment avec les technologies de dépôt précédemment discutées pour la formation de la couche 100.

Les parties verticales 301 de la couche 300 vont permettre d'accroître la largeur de matériau recouvrant les flancs des grilles 21 et, par conséquent, de réduire l'espace interstitiel entre deux composant micro-électronique adjacents, pour délimiter latéralement une deuxième implantation ionique. Avant cette implantation, il est cependant souhaitable d'éliminer au moins partiellement, mais de préférence totalement, les parties horizontales de la couche supérieure 300, au moins au niveau des zones de source/drain qui vont faire l'objet de la deuxième implantation. À cet effet, on peut réaliser une gravure anisotrope, en particulier dans un réacteur ICP, par exemple de type fluorocarbonée, pour l'attaque de nitrure de silicium. Cette étape est représentée aux figures 15A et 15B. La couche intermédiaire 200 est utilisée comme couche de limitation de cette gravure anisotrope et on utilisera avantageusement pour cette couche un matériau suffisamment sélectif par rapport à la chimie de la gravure anisotrope. On peut malgré tout tolérer une consommation partielle du matériau de la couche 200. Dans les parties horizontales de cette couche, on configurera la gravure de sorte à ce qu'il reste préférentiellement au moins 2 nm et/ou moins de 5 nm d'épaisseur du matériau de la couche 200. Alternativement ou cumulativement, on peut définir l'épaisseur résiduelle de la couche 200 dans ses parties horizontales à au moins 20% de son épaisseur initiale. En tout état de cause, le matériau de la couche supérieure 300 est totalement supprimé dans les parties horizontales couvrant les portions de la zone active destinées à former les sources/drains.

Dans cette situation, on réalise alors une deuxième implantation (de préférence de type HDD pour définir les accès Source/Drain proprement dits des transistors), de sorte à finaliser la fabrication des zones de sources/drains 160 comme le montre la figure 16B. Une étape de simulation pourra permettre d'ajuster la dose et l'énergie.

L'étape qui suit est un retrait des parties résiduelles de la couche supérieure 300. Cela peut se faire par une gravure isotrope, notamment une gravure humide, par exemple avec une solution d'acide phosphorique dans le cas d'une couche 300 de nitrure de silicium. Cette gravure s'arrête préférentiellement sur la couche intermédiaire 200, dont le matériau est préférentiellement sélectif relativement à ladite gravure. La couche 200 peut ensuite, quant à elle être retirée, toujours par exemple par l'intermédiaire d'une gravure isotrope, notamment de type humide, par exemple avec une solution d'acide fluorhydrique si la couche intermédiaire est faite de dioxyde de silicium.

De cette façon, les matériaux des couches 200 et 300 sont totalement supprimés à la surface du substrat. En outre, la ou les phases d'implantation ont conduit de manière inhérente à une modification du matériau de la première couche 100, dans les zones situées en surplomb des zones implantées, au niveau des portions de la zone active 11 donnant lieu à la fabrication des sources/ drains. De ce fait, le matériau se trouve fragilisé à ces endroits si bien que la gravure ayant permis le retrait de la couche intermédiaire 200 produit, si elle est poursuivie, une élimination des portions 101. De préférence, on utilise une solution d'attaque peu concentrée pour cette dernière gravure, et avec un temps limité, de sorte à supprimer les parties 101 sans pour autant consommer ou trop consommer le matériau sous-jacent à ces parties. Dans le cas de l'exemple d'une solution d'acide fluorhydrique, une concentration de 1% au plus donne satisfaction à cet effet. Alors que la gravure en question est de préférence sélective de sorte à ne pas attaquer le matériau d'espaceur, l'implantation est, de manière avantageuse, configurée pour transformer le matériau d'espaceur de sorte à le rendre plus sensible à cette gravure. Les parties verticales 102 ne sont donc pas ou sont peu affectées par la gravure, préservant les espaceurs 23.

Le résultat de ces phases d'élimination est révélé par les figures 17A et 17B.

Les figures 18A et 18B présentent une configuration après la réalisation d'étapes supplémentaires qui sont avantageusement mais non limitativement toutes opérées. L'une d'entre elles est la formation d'une couche de protection 4 sur les espaceurs 21 (elle n'est pas détaillée et peut être réalisée de manière conventionnelle, avec un dépôt pleine plaque d'un matériau tel que du nitrure de silicium, suivi d'une lithographie puis d'une gravure et d'un retrait du masque de lithographie pour ne préserver la couche de protection 4 qu'aux endroits utiles, à savoir en recouvrement de la surface latérale des espaceurs 21). Une autre étape supplémentaire est la formation d'une portion 5 par siliciuration superficielle du matériau servant à réaliser la grille 21 et des zones source-drain 160.

D'autre part, ces figures montrent le dépôt d'une couche contrainte 400. Typiquement, la couche contrainte 400 est une couche de nitrure. Il s'agit par exemple d'une couche de nitrure de silicium (SixNy x et y étant des entiers). De préférence, la couche contrainte 400 est en SiN. La formation de la couche contrainte comprend un dépôt conforme. Il est par exemple effectué par l'une des techniques suivantes de dépôt : dépôt chimique en phase vapeur assisté par plasma (PECVD, acronyme de plasma enhanced chemical vapor déposition), dépôt chimique en phase vapeur à basse pression (LPCVD, acronyme de low pressure CVD), dépôt thermique CVD rapide (RTCVD, acronyme de rapid thermal CVD), dépôt physique en phase vapeur (PVD, acronyme de physical vapor déposition), dépôt par couche atomique (ALD, acronyme de atomic layer déposition). D'autres types de dépôts peuvent être envisagés. Elle peut présenter une épaisseur de quelques nanomètres à quelques dizaines de nanomètres, et notamment une épaisseur comprise entre 5 et 40 nanomètres, par exemple 20 nm. Il n'est pas exclu de déposer une pluralité de couches contraintes 400 ou de limiter le revêtement de la couche contrainte 400 à une portion de la face du substrat, et, éventuellement, de revêtir au moins une autre portion de la face du substrat par au moins une autre couche contrainte, par exemple pour mettre en œuvre des contraintes de sens différents (en compression et en tension).

Un intérêt de l'invention est d'accroître la fiabilité de fabrication des composants ce qui est particulièrement utile dans le cas où une couche 500 d'isolant électrique est ensuite rapportée sur la face du substrat 1, par exemple une couche de dioxyde de silicium, notamment pour une incorporation du niveau de composants électriques ainsi fabriqués dans un dispositif micro-électronique plus complexe, comprenant par exemple une pluralité d'étages, dont le niveau ainsi fabriqué peut constituer une partie intermédiaire, notamment une partie de milieu de lignes, connue sous la dénomination « Middle of Line ». On pourra utiliser les techniques de dépôt précédemment évoquées pour les couches 100 à 400 pour la réalisation de ce remplissage par la couche 500. Les figures 19A et 19B montrent un tel remplissage avec une bonne succession des couches, sans vide. En effet, la protection offerte durant les phases précédentes par les parties 101 de la première couche 100, puis par les parties horizontales des couches 200 et 300, ont permis de protéger les matériaux sous-jacents, et en particulier le matériau des zones électriquement isolantes 12, lors des étapes de fabrication durant lesquelles ces protections étaient présentes. N'étant pas creusées, les portions de matériau isolant des zones 12 ne subissent pas un accroissement indésirable de leur rapport de forme, ce qui gênait jusqu'à présent les remplissages ultérieurs à ce niveau.

On peut ainsi former des contacts électriques traversant la couche électriquement isolante 500 et rejoignant l'une des parties fonctionnelles du composant MOS (telles que les zones source/drain), sans risque de remplissage intempestif d'un vide résiduel dans l'empilement des couches précédentes. Notamment, de tels contacts peuvent être métalliques, par exemple en tungstène, et l'absence de vide interdit la diffusion du matériau des contacts au sein des zones d'isolation électrique 12, entre deux zones actives 11.

## Revendications

1. Procédé de réalisation d'au moins un composant microélectronique sur un substrat (1) qui comporte, de manière exposée sur une première face du substrat (1), au moins une zone active (11) et au moins une zone d'isolation électrique (12) adjacente à la zone active (11), le procédé comprenant une formation d'une grille (21) de transistor sur la zone active (11), une formation d'espaceurs (23) chacun configuré pour couvrir une surface d'un flanc différent de la grille (21), et une formation de zones de source et de drain par dopage de portions de la zone active adjacentes à la grille, le procédé comprenant, de manière successive :
- une formation d'une première couche (100), en un matériau d'espaceur, au-dessus de la zone active (11) et au-dessus de la zone d'isolation électrique (12) ;
- une implantation ionique configurée pour produire le dopage des portions de la zone active (11) adjacentes à la grille (21) au travers de la première couche (100), la première couche (100) formant un revêtement de protection de la zone d'isolation électrique (12) durant toute l'implantation et jusqu'à son achèvement ;
- une élimination d'une portion modifiée de la première couche (100) située en surplomb de la zone active (11) et de la zone d'isolation électrique (12), ladite portion modifiée étant issue de l'implantation ionique, ladite élimination étant configurée pour préserver, au moins en partie, la première couche (100) au niveau des flancs de la grille (21).

2. Procédé selon la revendication précédente, comprenant un retrait partiel préliminaire de la première couche (100) avant l'implantation, avec une gravure anisotrope configurée pour réduire, sans l'éliminer totalement, l'épaisseur de la première couche (100) au-dessus de la zone active (11) et au-dessus de la zone d'isolation électrique (12).

3. Procédé selon la revendication précédente, dans lequel la gravure anisotrope est configurée pour préserver une épaisseur de la première couche (100) d'au moins 2 nm, et de préférence 3 nm, au-dessus de la zone active (11) et au-dessus de la zone d'isolation électrique (12).

4. Procédé selon l'une des deux revendications précédentes, dans lequel la gravure anisotrope est configurée pour préserver une épaisseur de la première couche (100) d'au plus 5 nm au-dessus de la zone active (11) et au-dessus de la zone d'isolation électrique (12).

5. Procédé selon l'une des revendications précédentes, dans lequel l'implantation ionique comprend une première implantation ionique et, successivement, après la première implantation ionique et avant l'élimination d'une portion modifiée :
- une formation, sur la première couche (100), d'au moins une couche supplémentaire ;
- une deuxième implantation ionique configurée pour produire un deuxième dopage des portions de la zone active (11) adjacentes à la grille (21).

6. Procédé selon la revendication précédente, dans lequel la formation, sur la première couche (100), d'au moins une couche supplémentaire comprend :
- une formation, sur la première couche (100), d'une couche intermédiaire (200), en un deuxième matériau différent du matériau d'espaceur;
- une formation, sur la couche intermédiaire (200), d'une couche supérieure (300), en un troisième matériau différent du deuxième matériau.

7. Procédé selon la revendication précédente comprenant, après la formation de la couche supérieure (300) :
- un retrait, au moins partiel, des parties horizontales de la couche supérieure (300) avec une première gravure, anisotrope ;
- la deuxième implantation ionique;
- un retrait complet de la couche supérieure (300), comprenant une deuxième gravure employant la couche intermédiaire (200) comme couche d'arrêt;
- un retrait complet de la couche intermédiaire (200), comprenant une troisième gravure qui est sélective relativement au matériau d'espaceur.

8. Procédé selon la revendication précédente, dans lequel le retrait des parties horizontales de la couche supérieure (300) est total, en employant la couche intermédiaire (200) comme couche d'arrêt de la première gravure.

9. Procédé selon l'une des deux revendications précédentes, dans lequel la troisième gravure est configurée pour produire, après le retrait de la couche intermédiaire (200), l'élimination d'une portion modifiée de la première couche (100), ladite portion modifiée étant issue de l'implantation ionique.

10. Procédé selon l'une des trois revendications précédentes, dans lequel la deuxième gravure est isotrope.

11. Procédé selon l'une des quatre revendications précédentes, dans lequel la troisième gravure est isotrope.

12. Procédé selon l'une des six revendications précédentes, dans lequel le troisième matériau est choisi identique au matériau d'espaceur.

13. Procédé selon l'une des revendications précédentes, comprenant, après l'élimination d'une portion modifiée, une formation d'au moins une couche contrainte (400) configurée pour couvrir, en la mettant en tension ou en compression, une portion du substrat (1) comprenant au moins une zone de source ou une zone de drain.

14. Procédé selon la revendication précédente, comprenant après la formation de l'au moins une couche contrainte (400), une formation d'une couche électriquement isolante (500).

15. Procédé selon la revendication précédente, comprenant, après la formation d'une couche électriquement isolante, une formation d'au moins un élément de contact électrique (8) en liaison électrique avec une zone de drain ou de source sous-jacente.

## Patentansprüche

1. Verfahren zur Umsetzung von mindestens einer mikroelektronischen Komponente auf einem Substrat (1), das auf freigelegte Weise auf einer ersten Fläche des Substrats (1) mindestens eine aktive Zone (11) und mindestens eine elektrische Isolationszone (12) angrenzend an die aktive Zone (11) umfasst, wobei das Verfahren ein Bilden eines Transistor-Gates (21) auf der aktiven Zone (11), ein Bilden von Abstandshaltern (23), die jeweils dazu konfiguriert sind, eine Oberfläche einer anderen Seite des Gates (21) abzudecken, und ein Bilden von Source- und Drain-Zonen durch Dotieren von Abschnitten der aktiven Zone angrenzend an das Gate umfasst,
wobei das Verfahren auf aufeinanderfolgende Weise umfasst:
- ein Bilden einer ersten Schicht (100) aus einem Abstandshaltermaterial über der aktiven Zone (11) und über der elektrischen Isolationszone (12);
- ein lonenimplantieren, das dazu konfiguriert ist, das Dotieren von Abschnitten der aktiven Zone (11) angrenzend an das Gate (21) durch die erste Schicht (100) zu bewirken, wobei die erste Schicht (100) einen Schutzüberzug der elektrischen Isolationszone (12) während des gesamten Implantierens und bis zu dessen Abschluss bildet;
- ein Entfernen eines modifizierten Abschnitts der ersten Schicht (100), der über die aktive Zone (11) und die elektrische Isolationszone (12) überhängt, wobei der modifizierte Abschnitt aus dem lonenimplantieren hervorgeht, wobei das Entfernen dazu konfiguriert ist, die erste Schicht (100) auf der Ebene der Seiten des Gates (21) zumindest partiell zu bewahren.

2. Verfahren nach dem vorhergehenden Anspruch, umfassend ein vorläufiges partielles Abziehen der ersten Schicht (100) vor dem Implantieren mit einem anisotropen Ätzen, das dazu konfiguriert ist, die Dicke der ersten Schicht (100) über der aktiven Zone (11) und über der elektrischen Isolationszone (12) zu verringern, ohne sie vollständig zu entfernen.

3. Verfahren nach dem vorhergehenden Anspruch, wobei das anisotrope Ätzen dazu konfiguriert ist, eine Dicke der ersten Schicht (100) von mindestens 2 nm und vorzugsweise 3 nm über der aktiven Zone (11) und über der elektrischen Isolationszone (12) zu bewahren.

4. Verfahren nach einem der zwei vorhergehenden Ansprüche, wobei das anisotrope Ätzen dazu konfiguriert ist, eine Dicke der ersten Schicht (100) von höchstens 5 nm über der aktiven Zone (11) und über der elektrischen Isolationszone (12) zu bewahren.

5. Verfahren nach einem der vorhergehenden Ansprüche, wobei das lonenimplantieren ein erstes lonenimplantieren und nacheinander nach dem ersten lonenimplantieren und vor dem Entfernen eines modifizierten Abschnitts:
- ein Bilden von mindestens einer zusätzlichen Schicht auf der ersten Schicht (100);
- ein zweites lonenimplantieren, das dazu konfiguriert ist, ein zweites Dotieren von Abschnitten der aktiven Zone (11) angrenzend an das Gate (21) zu bewirken, umfasst.

6. Verfahren nach dem vorhergehenden Anspruch, wobei das Bilden von mindestens einer zusätzlichen Schicht auf der ersten Schicht (100) umfasst:
- ein Bilden von einer Zwischenschicht (200) aus einem zweiten Material, das sich von dem Abstandshaltermaterial unterscheidet, auf der ersten Schicht (100),
- ein Bilden einer oberen Schicht (300) aus einem dritten Material, das sich von dem zweiten Material unterscheidet, auf der Zwischenschicht (200).

7. Verfahren nach dem vorhergehenden Anspruch, umfassend nach dem Bilden der oberen Schicht (300):
- ein zumindest partielles Abziehen von horizontalen Teilen der oberen Schicht (300) mit einem ersten anisotropen Ätzen;
- das zweite lonenimplantieren;
- ein komplettes Abziehen der oberen Schicht (300), umfassend ein zweites Ätzen, das die Zwischenschicht (200) als Stoppschicht einsetzt;
- ein komplettes Abziehen der Zwischenschicht (200), umfassend ein drittes Ätzen, das in Bezug auf das Abstandshaltermaterial selektiv ist.

8. Verfahren nach dem vorhergehenden Anspruch, wobei das Abziehen von horizontalen Teilen der oberen Schicht (300) durch Einsetzen der Zwischenschicht (200) als Stoppschicht des ersten Ätzens vollständig ist.

9. Verfahren nach einem der zwei vorhergehenden Ansprüche, wobei das dritte Ätzen dazu konfiguriert ist, nach dem Abziehen der Zwischenschicht (200) das Entfernen eines modifizierten Abschnitts der ersten Schicht (100) zu bewirken, wobei der modifizierte Abschnitt aus dem lonenimplantieren hervorgeht.

10. Verfahren nach einem der drei vorhergehenden Ansprüche, wobei das zweite Ätzen isotrop ist.

11. Verfahren nach einem der vier vorhergehenden Ansprüche, wobei das dritte Ätzen isotrop ist.

12. Verfahren nach einem der sechs vorhergehenden Ansprüche, wobei das dritte Material identisch zu dem Abstandshaltermaterial ausgewählt wird.

13. Verfahren nach einem der vorhergehenden Ansprüche, umfassend nach dem Entfernen eines modifizierten Abschnitts ein Bilden von mindestens einer Beschränkungsschicht (400), die dazu konfiguriert ist, einen Abschnitt des Substrats (1), umfassend mindestens eine Source-Zone oder eine Drain-Zone, abzudecken, indem sie gespannt oder komprimiert wird.

14. Verfahren nach dem vorhergehenden Anspruch, umfassend nach dem Bilden der mindestens einen Beschränkungsschicht (400) ein Bilden einer elektrisch isolierenden Schicht (500).

15. Verfahren nach dem vorhergehenden Anspruch, umfassend nach dem Bilden einer elektrisch isolierenden Schicht ein Bilden von mindestens einem elektrischen Kontaktelement (8) in elektrischer Verbindung mit einer darunterliegenden Drain-Zone oder einer Source-Zone.

## Claims

1. Method for producing at least one microelectronic component on a substrate (1) which includes, exposed on a first face of the substrate (1), at least one active region (11) and at least one electrically insulating region (12) adjacent to the active region (11), the method comprising forming a transistor gate (21) on the active region (11), forming spacers (23) each configured to cover a surface of a different sidewall of the gate (21), and forming source and drain regions by doping portions of the active region adjacent to the gate, the method successively comprising:
- forming a first layer (100), made of a spacer material, above the active region (11) and above the electrically insulating region (12);
- carrying out ion implantation configured to produce the doping of the portions of the active region (11) adjacent to the gate (21) through the first layer (100), the first layer (100) forming a protective coating protecting the electrically insulating region (12) throughout the implantation and until completion thereof;
- removing a modified portion of the first layer (100) overhanging the active region (11) and the electrically insulating region (12), said modified portion originating from the ion implantation, said removal being configured to at least partially preserve the first layer (100) at the sidewalls of the gate (21).

2. Method according to the preceding claim, comprising a preliminary partial removal of the first layer (100) before the implantation, with anisotropic etching configured to reduce, without totally removing, the thickness of the first layer (100) above the active region (11) and above the electrically insulating region (12).

3. Method according to the preceding claim, wherein the anisotropic etch is configured to preserve a thickness of the first layer (100) of at least 2 nm, and preferably 3 nm, above the active region (11) and above the electrically insulating region (12).

4. Method according to one of the preceding two claims, wherein the anisotropic etch is configured to preserve a thickness of the first layer (100) of no more than 5 nm above the active region (11) and above the electrically insulating region (12).

5. Method according to one of the preceding claims, wherein the ion implantation comprises carrying out a first ion implantation and, successively, after the first ion implantation and before the removal of a modified portion:
- forming at least one additional layer on the first layer (100);
- carrying out a second ion implantation configured to produce a second doping of the portions of the active region (11) adjacent to the gate (21).

6. Method according to the preceding claim, wherein the formation of at least one additional layer on the first layer (100), comprises:
- forming an intermediate layer (200) made of a second material that is different from the spacer material, on the first layer (100);
- forming a top layer (300) made of a third material that is different from the second material, on the intermediate layer (200).

7. Method according to the preceding claim, comprising, after the formation of the top layer (300):
- at least partially removing the horizontal parts of the top layer (300) with a first, anisotropic etch;
- carrying out the second ion implantation;
- completely removing the top layer (300), which removal comprises a second etch using the intermediate layer (200) as an etch stop layer;
- completely removing the intermediate layer (200), which removal comprises a third etch which is selective to the spacer material.

8. Method according to the preceding claim, wherein the horizontal parts of the top layer (300) are removed in full, using the intermediate layer (200) as an etch stop layer for the first etch.

9. Method according to one of the preceding two claims, wherein the third etch is configured to cause, after removal of the intermediate layer (200), the removal of a modified portion of the first layer (100), said modified portion originating from the ion implantation.

10. Method according to one of the preceding three claims, wherein the second etch is isotropic.

11. Method according to one of the preceding four claims, wherein the third etch is isotropic.

12. Method according to one of the preceding six claims, wherein the third material is chosen such that it is identical to the spacer material.

13. Method according to one of the preceding claims, comprising, after the removal of a modified portion, forming at least one stressed layer (400) configured to cover, by being placed under tensile or compressive stress, a portion of the substrate (1) comprising at least a source region or a drain region.

14. Method according to the preceding claim, comprising, after the formation of the at least one stressed layer (400), forming an electrically insulating layer (500).

15. Method according to the preceding claim, comprising, after the formation of an electrically insulating layer, forming at least one electrical contact element (8) in electrical connection with an underlying source or drain region.
